Europäisches Patentamt

European Patent Office

Office européen des brevets

(11) Publication number: **0 190 051 B1**

# EUROPEAN PATENT SPECIFICATION

(45) Date of publication of patent specification: **25.03.92**    (51) Int. Cl.⁵: **C23C  14/34**

(21) Application number: **86300646.6**

(22) Date of filing: **30.01.86**

The file contains technical information submitted
after the application was filed and not included in
this specification

(54) **Method and apparatus for forming films.**

(30) Priority: **30.01.85 JP 15819/85**

(43) Date of publication of application:
**06.08.86 Bulletin  86/32**

(45) Publication of the grant of the patent:
**25.03.92 Bulletin  92/13**

(84) Designated Contracting States:
**DE FR GB**

(56) References cited:
**DE-B- 1 237 400**
**FR-A- 2 519 351**

**IBM TECHNICAL DISCLOSURE BULLETIN, vol.
24, no. 2, July 1981, pages 1077-1078, New
York, US; J.J. CUOMO et al.: "Step coverage
during thin film deposition"**

**PATENT ABSTRACTS OF JAPAN, vol. 7, no.
34 (C-150)[1179], 10th February 1983 & JP-
A-57-188 673**

**IBM TECHNICAL DISCLOSURE BULLETIN, vol.
24, no. 1B, June 1981, page 746, New York,
US; C.J. KIRCHER et al.: "Evaporation of
stress-free films"**

(73) Proprietor: **KABUSHIKI KAISHA TOSHIBA
72, Horikawa-cho Saiwai-ku
Kawasaki-shi Kanagawa-ken 210(JP)**

(72) Inventor: **Matsuda, Tetsuo
2686-11, Yaho
Kunitachi-shi Tokyo(JP)**
Inventor: **Ito, Hitoshi
7-14-18, Shimorenjaku
Mitaka-shi Tokyo(JP)**

(74) Representative: **Freed, Arthur Woolf et al
MARKS & CLERK 57-60 Lincoln's Inn Fields
London WC2A 3LS(GB)**

Note: Within nine months from the publication of the mention of the grant of the European patent, any person
may give notice to the European Patent Office of opposition to the European patent granted. Notice of opposition
shall be filed in a written reasoned statement. It shall not be deemed to have been filed until the opposition fee
has been paid (Art. 99(1) European patent convention).

EP 0 190 051 B1

PATENT ABSTRACTS OF JAPAN, vol. 4, no. 16 (C-72)[130], 7th February 1980 & JP-A-54-152 634

JOURNAL OF APPLIED PHYSICS, vol. 55, no. 1, January 1984, pages 235-241, American Institute of Physics, New York, US; P.J. MARTIN et al.: "Modification of the optical and structural properties of dielectric ZrO2 films by ion-assisted deposition"

PATENT ABSTRACTS OF JAPAN, vol. 9, no. 180 (C-293)[1903], 25th July 1985 & JP-A-60-50 166

## Description

This invention relates to a method and an apparatus for forming films by sputtering, and more particularly a method and an apparatus for forming a film by sputtering having an excellent hole or step covering capability by irradiating the film with light during the sputtering process.

Sputtering is used as one method of forming a film on a substrate such as a semiconductor wafer.

In a conventional sputtering method, ions created by electric discharge in a pressure reduced atmosphere at a pressure of about 13.2 - 0.0132 Pa ($10^{-1}$ - $10^{-4}$ Torr) and having high kinetic energy are accelerated to collide upon a target electrode, and atoms emitted from the target electrode as a result of sputtering are caused to deposit on a substrate so as to form a film.

With the method of forming a film by sputtering, however, step covering capability, that is, capability of uniformly covering a stepped surface, is not good. Thus, as shown in Fig.4, when a film 22 is deposited on a substrate 21 having a step or irregularity caused by a groove or opening on the substrate, or shoulders at edge portions, the thickness of the covered film decreases at the bottom A of the groove or opening 23 or at the shoulder at the end of a pattern. In the case of a groove or opening 23, a cavity B might be formed.

To solve this problem, a method has been proposed wherein the gas pressure of the atmosphere in a sputtering apparatus is reduced so as to reduce the pressure of atmosphere at the time of deposition. According to this method, since the energy loss caused by the collision of ions with the atmospheric gas decreases with decrease in the atmospheric gas pressure in the sputtering apparatus, atoms having large energy will satisfactorily deposit on the bottom of the groove or opening. Accordingly, the lower is the pressure, the higher is the coating efficiency at the stepped surface. However, lowering the pressure not only decreases the deposition speed of the film but also requires an expensive evacuated apparatus, thus decreasing productivity and increasing production cost.

IBM Technical Disclosure Bulletin Vol. 24, July 1981, pages 1077-1078 discloses an ion beam sputtering method in which, in order to alleviate the described problem, the growing film itself is bombarded with second ion beam during deposition.

It is therefore an object of this invention to provide a novel method and an apparatus for forming a film having excellent step coating capability.

The above object is met by the method set out in claim 1. An apparatus for carrying out the method of the present invention is set out in claim 5.

In the accompanying drawings:

Fig. 1 is a sectional view showing an embodiment of the sputtering apparatus according to this invention adapted to form a silicon oxide film;

Fig. 2 is a sectional view showing a silicon oxide film formed over a stepped surface by the method of this invention;

Fig. 3 is a graph showing the relationship between the output of an irradiation light source at the time of forming a silicon oxide film and a ratio $T_{min}/T_{max}$, where $T_{min}$ designates the minimum film thickness, and $T_{max}$ the maximum film thickness; and

Fig. 4 shows a sectional view of a film formed over a stepped surface with a prior art method.

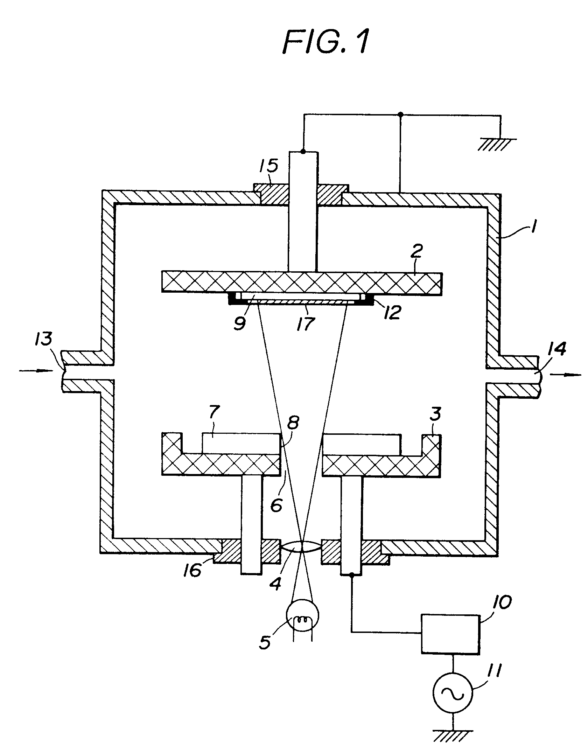

The sputtering apparatus shown in Fig.1 comprises a casing 1, a flat plate shaped upper electrode (anode) 2 and a lower electrode (cathode) 3 confronting with the upper electrode, a lens 4 disposed in an opening at the bottom of the casing, and a light source 5 for irradiating, through lens 4, a substrate supported by the anode 2.

The lower electrode 3 is formed with a circular window 6 at its center, and a target 7 mounted on the lower electrode 3 is also formed with a window 8 in alignment with window 6 so that the light emitted from the light source 5 is transmitted to the substrate 9 through these windows.

The lower electrode 3 is connected to a high frequency source 11 through a matching circuit 10 so that the lower electrode is fed with high frequency power.

The upper electrode is grounded and supports the substrate 9 with a support holder 12. The spacing between the substrate 9 and the target 7 is 50 mm, for example.

On both sides of the casing 1 are formed a gas inlet port 13 and a gas exit port 14 confronting with each other. The anode and cathode electrodes are respectively insulated from the casing 1 by insulators 15 and 16.

A method of forming a silicon oxide film by using the sputtering apparatus will now be described.

The silicon substrate 9 incorporated with predetermined element regions is held at a predetermined position by means of the substrate holder 12, and the target material 7 made of quartz glass ($SiO_2$) is mounted on the lower electrode 3.

After evacuating the interior of the casing 1 to a vacuum degree of about $1.32 \times 10^{-5}$ Pa ($1 \times 10^{-7}$ Torr), argon gas (Ar) is introduced into the casing 1 through the gas inlet port 13 to maintain the gas pressure in the casing at a pressure of $1.32 \times 10^{-6}$ Pa ($1 \times 10^{-8}$ Torr).

Under this condition, a high frequency power of 1 kW is applied across the upper and lower electrodes 2 and 3 for striking an electric discharge therebetween. At the same time, 1 kW of light and 1000 nm wavelength is admitted into the casing 1 though the lens 4 for irradiating the surface of the substrate through the windows 6 and 8 of the lower electrode 3 and the target 7.

Argon ions created by electric discharge sputter the target 7 thereby forming a film 17 of silicon oxide on the surface of the substrate.

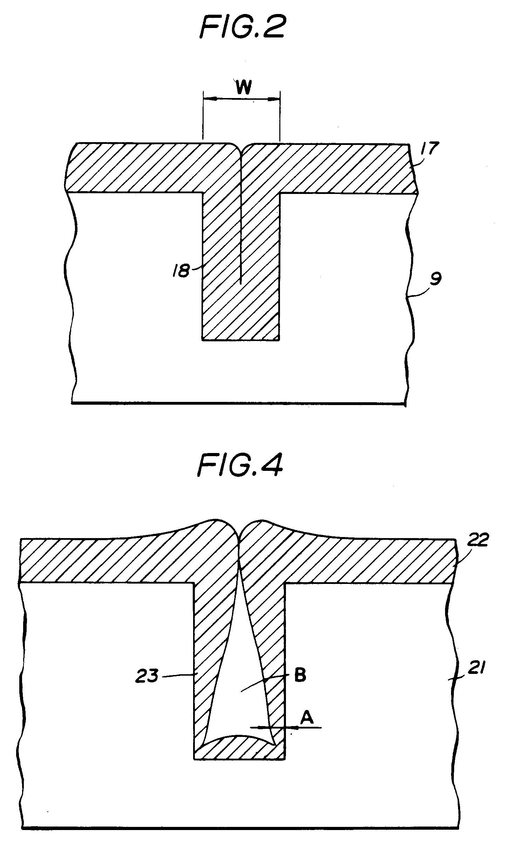

Fig.2 shows the substrate 9 on which the silicon oxide film 17 having a thickness of about 800 nm is formed. As can be noted from Fig.2, even when there is an opening 18 having a width W = 1400 nm and a depth of 800 nm, the silicon oxide film 17 can be formed without forming a cavity.

Fig.4 shows a cross-section of a film with prior art method. Comparison of Fig.2 with Fig.4 shows that according to this invention, since sputtering is made while projecting light, it is possible to form a film (in this example, a silicon oxide film) having an excellent step or opening coating capability. This is because the silicon oxide molecules formed by sputtering the target are activated by light on the surface of the substrate so that the silicon oxide molecules can reach the bottom of the opening.

Furthermore, as the temperature of the substrate surface is raised, the deposition speed of the film is increased, thus making it possible to form an excellent film in a short time.

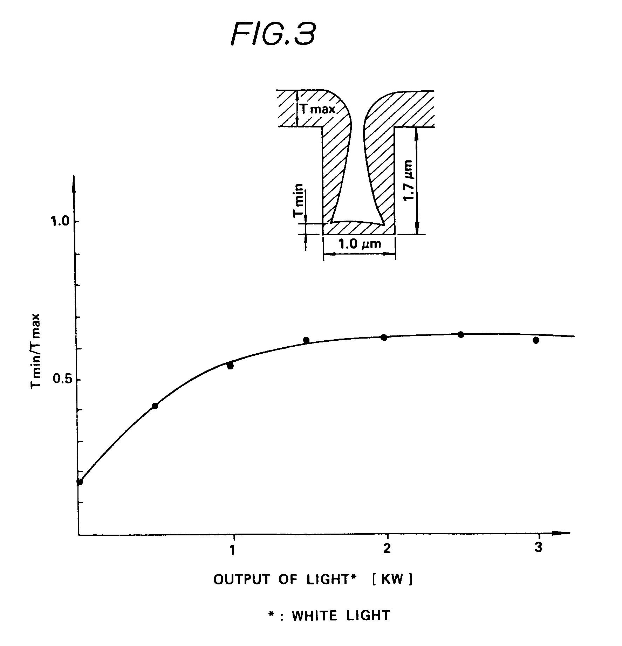

The curve shown in Fig.3 shows the relationship between the light output of the light source and a ratio $T_{min}/T_{max}$, where $T_{min}$ represents the minimum film thickness, and $T_{max}$ the maximum film thickness. As can be noted from this curve, where light output is zero, that is when sputtering is made without light irradiation the ratio $T_{min}/T_{max}$ is 0.16. However, when the light output is made 2 kW or higher, the ratio $T_{min}/T_{max}$ becomes 0.65, which means that, regardless of the presence of an opening, a film of uniform thickness can be formed.

It should be understood that the invention is not limited to the specific embodiment described above. For example, the light for activation may be projected obliquely and any wavelength of light can be used.

Furthermore, the invention was described to form a silicon oxide film, a film of refractory metal, a silicide film of refractory metal, a polycrystalline silicon film, etc. can also be formed by the method of this invention.

As above described, when atoms emitted from a target as a result of sputtering of ions created by electric discharge reach the surface of a substrate, since the surface of the substrate is activated by light, the atoms can readily reach the bottom of a groove or opening, or of a stepped portion at an end of a pattern, whereby the film can fill the groove or opening without forming a cavity, thus greatly improving step covering capability.

Where the wavelength of the light is selected to be long (for example, λ > 5000 nm), the substrate is heated by the light, thereby improving the deposition speed.

On the other hand, when the wavelength is selected to be short (for example, λ < 1000 nm), the substrate temperature is not raised appreciably, and yet the deposition speed does not decrease compared with the case of no irradiation of light and it is possible to form a dense film having an excellent step covering capability. In this case, film can be coated on a substrate containing non-refractory metal.

## Claims

1. A method of forming a film (17) of the type wherein a target electrode (7) is sputtered by ions formed by electric discharge for depositing material of the target electrode (7) on the surface of a substrate (9) having a groove (18) or stepped portion to form a film (17), characterized by the step of irradiating the said surface with light while depositing said material on said surface, the light being of an intensity sufficient to cause the film to fill the groove (18) without forming a cavity or to cover the stepped portion uniformly.

2. The method according to claim 1 wherein said substrate contains non-refractory metal and said light has a wavelength shorter than 1000 nm.

3. The method according to claim 1 wherein said film is made of silicon oxide and said light has a wavelength longer than 5000 nm.

4. The method according to claim 1 wherein said film is made of a member selected from the group consisting of refractory metals, silicide of refractory metal, and polycrystalline silicon.

5. Film forming apparatus for carrying out the method of any of claims 1 to 4 of the type wherein ions formed by electric discharge are caused to collide upon a target electrode (7) and atoms emitted from the target electrode (7) as a result of sputtering are deposited on the surface of a substrate (9) characterized in that there is provided means (4,5) for projecting light of a predetermined wavelength upon the substrate (g).

## Revendications

1. Un procédé pour la formation d'un film (17) dans lequel une électrode cible (7) est bombardée par des ions formés par décharge électrique en vue du dépôt de matériau de l'électrode cible (7) sur la surface d'un substrat (9) comportant une rainure (18) ou une partie étagée pour former un film (17), caractérisé par l'étape d'irradiation de ladite surface à la lumière pendant le dépôt du dit matériau sur ladite surface, la lumière ayant une intensité suffisante pour entraîner le film à combler la rainure (18) sans formation d'une cavité ou à couvrir uniformément la partie étagée.

2. Le procédé selon la revendication 1, dans lequel ledit substrat contient un métal non réfractaire et dans lequel ladite lumière a une longueur d'onde inférieure à 1000 nm.

3. Le procédé selon la revendication 1, dans lequel ledit film est composé d'oxyde de silicium et dans lequel ladite lumière a une longueur d'onde supérieure à 5000 nm.

4. Le procédé selon la revendication 1, dans lequel ledit film se compose d'un matériau sélectionné dans le groupe comprenant les métaux réfractaires, les réfractaires à base de siliciures, et le silicium polycristallin.

5. Un appareil pour la formation de films permettant la mise en application du procédé selon l'une quelconque des revendications 1 à 4, dans lequel des ions formés par décharge électrique sont entraînés à se heurter contre une électrode cible (7) et dans lequel des atomes émis par l'électrode cible (7), résultant du bombardement, sont déposés sur la surface d'un substrat (9), caractérisé en ce qu'il existe un moyen (4,5) pour projeter de la lumière d'une longueur d'onde prédéterminée sur le substrat (9).

**Patentansprüche**

1. Verfahren zur Bildung eines Films (17) von dem Typ, bei welchem eine Zielelektrode (7) durch Ionen gesputtert wird, die durch elektrische Entladung gebildet sind, um zur Bildung eines Films (17) Material der gesputterten Zielelektrode (7) auf der Oberfläche eines Substrats (9) abzulagern, das eine Rille (18) oder einen gestuften Bereich aufweist, gekennzeichnet durch den Schritt des Bestrahlens der Oberfläche mit Licht während des Ablagerns des Materials auf der Oberfläche, wobei das Licht eine Intensität aufweist, die ausreicht, zu bewirken, daß der Film die Rille (18) ausfüllt, ohne einen Hohlraum zu bilden, oder daß der Film den gestuften Bereich gleichmäßig bedeckt.

2. Verfahren nach Anspruch 1, bei dem das Substrat nicht-feuerfestes Metall aufweist und das Licht eine Wellenlänge hat, die kürzer als 1000 nm ist.

3. Verfahren nach Anspruch 1, bei dem der Film aus Siliziumoxid besteht und das Licht eine Wellenlänge hat, die länger als 5000 nm ist.

4. Verfahren nach Anspruch 1, bei dem der Film aus einem Element besteht, das aus der aus nicht-feuerfesten Metallen, dem Silizid nicht-feuerfester Metalle und polykristallinem Silizium bestehenden Gruppe ausgewählt ist.

5. Filmbildungsgerät zur Durchführung des Verfahrens nach einem der Ansprüche 1 bis 4 von dem Typ, bei dem durch elektrische Entladung gebildete Ionen zum Aufprall auf einer Zielelektrode (7) gebracht werden und infolge des Sputterns von der Zielelektrode (7) emittierte Atome auf der Oberfläche eines Substrats (9) abgelagert werden, dadurch gekennzeichnet, daß eine Einrichtung (4, 5) zum Projizieren von Licht einer vorbestimmten Wellenlänge auf das Substrat (9) vorgesehen ist.

# FIG.1

## FIG.2

W

17

18

9

## FIG.4

22

23

B

A

21

# FIG.3

OUTPUT OF LIGHT*  [ KW ]

*  : WHITE LIGHT